# FASCICULE DE BREVET EUROPEEN

(11) **EP 4 377 491 B1**
(45) Date de publication et mention de la délivrance du brevet: **29.04.2026**
(21) Numéro de dépôt: 22755218.9
(22) Date de dépôt: 27.07.2022
(51) Int. Cl.: C23C 14/14, C23C 14/08, C23C 14/50, C23C 14/46, H01L 21/443, H01L 21/441, H10H 20/819, H10H 20/831

(54) **PROCÉDÉ DE FABRICATION D'UN DISPOSITIF OPTOÉLECTRONIQUE COMPORTANT UNE ÉTAPE DE RÉALISATION D'UNE COUCHE MINCE CONDUCTRICE DE MANIÈRE CONFORME ET CONTINUE PAR DÉPÔT DIRECTIF**
VERFAHREN ZUR HERSTELLUNG EINER OPTOELEKTRONISCHEN VORRICHTUNG MIT EINEM SCHRITT ZUR GLEICHMÄSSIG UND KONTINUIERLICHEN HERSTELLUNG EINER DÜNNEN LEITENDEN SCHICHT DURCH GERICHTETE ABSCHEIDUNG
PROCESS FOR FABRICATING AN OPTOELECTRONIC DEVICE COMPRISING A STEP OF PRODUCING A THIN CONDUCTIVE LAYER CONFORMALLY AND CONTINOUSLY BY DIRECTIONAL DEPOSITION

(30) Priorité: 30.07.2021 FR 2108386
(43) Date de publication de la demande: 05.06.2024
(73) Titulaire: Commissariat à l'Energie Atomique et aux Energies Alternatives, 75015 Paris (FR)
(72) Inventeur: DUPRE, Ludovic, 38054 Grenoble Cedex 09 (FR); FOURNIER, Hélène, 38054 Grenoble Cedex 09 (FR)
(74) Mandataire: INNOV-GROUP
(86) Numéro de dépôt international: PCT/EP2022/071135
(87) Numéro de publication internationale: WO 2023/006846

(56) Documents cités:
- FR-A1- 3 068 514
- US-A1- 2019 319 066
- US-A1- 2021 135 150

## Description

### DOMAINE TECHNIQUE

Le domaine de l'invention est celui des procédés de fabrication d'un dispositif optoélectronique comportant des diodes filaires d'émission ou de réception de lumière qui reposent sur un substrat, et porte plus précisément sur la réalisation sur la face avant du substrat d'une électrode en couche mince adaptée à polariser les diodes filaires.

### ÉTAT DE LA TECHNIQUE ANTÉRIEURE

Il existe des dispositifs optoélectroniques comportant des structures semiconductrices tridimensionnelles de type nanofils ou microfils formant par exemple des diodes électroluminescentes dites filaires. Les diodes filaires comportent habituellement une première portion s'étendant à partir du substrat, dopée par exemple de type n, et une seconde portion qui repose sur la première portion dopée, dopée du type de conductivité opposé par exemple de type p, entre lesquelles se situe une zone active assurant l'émission du rayonnement lumineux.

La polarisation électrique des premières portions dopées peut être effectuée en face avant du substrat, par exemple au moyen d'une couche de nucléation réalisée en un matériau électriquement conducteur. Un tel exemple est notamment décrit dans le document EP3479409A1 et dans le document WO2019129978A1. Cependant, cela nécessite d'utiliser un matériau qui soit non seulement électriquement conducteur mais également adapté à la croissance épitaxiale des diodes filaires.

Il est également connu de doper localement le substrat de sorte qu'il présente des zones dopées de type n, affleurant la face avant du substrat, autorisant le déplacement des porteurs de charge jusqu'au pied des diodes filaires. Un tel exemple est notamment décrit dans le document WO2015/044619A1. Cependant, cela nécessite d'effectuer des étapes préalables de dopage localisé du substrat de croissance.

Le document US2021/135150 divulgue le dépôt d'un revêtement conducteur dans le cadre de la fabrication d'un dispositif OLED, dans lequel un flux évaporé est réalisé suivant une direction de dépôt orientée vers le substrat, avec rotation du substrat pendant le dépôt.

Il existe donc un besoin de disposer d'un procédé de fabrication d'un tel dispositif optoélectronique à diodes filaires qui assure une polarisation électrique simple et efficace des diodes filaires en face avant du substrat.

### EXPOSÉ DE L'INVENTION

L'invention a pour objectif de remédier au moins en partie aux inconvénients de l'art antérieur, et plus particulièrement de proposer un procédé de fabrication d'un dispositif optoélectronique à diodes filaires, comportant une étape de réalisation par dépôt directif d'une électrode inférieure en couche mince qui s'étend sur la face avant du substrat de manière conforme et continue.

Pour cela, l'objet de l'invention est un procédé de fabrication d'un dispositif optoélectronique comportant : un substrat, et une pluralité de diodes filaires d'émission ou de détection de lumière reposant sur le substrat, présentant chacune une hauteur moyenne h et étant espacées avec un espacement relatif moyen d de flanc à flanc, tels qu'un rapport d'aspect d'espacement h/d est au moins égal à 1.

Le procédé comporte une étape de réalisation d'une couche mince conductrice inférieure, en au moins un matériau électriquement conducteur, et destinée à former une électrode inférieure, effectuée par dépôt physique en phase vapeur directif suivant une direction principale de dépôt D_{d} orientée vers le substrat et les diodes filaires, se traduisant par un flux de matière incident du matériau électriquement conducteur.

Lors du dépôt, le substrat repose sur un support d'un porte-substrat, le support présentant : un mouvement périodique rotatif de sorte que les flancs des diodes filaires sont exposés au flux de matière incident à une fréquence de rotation fᵣ; et un mouvement périodique d'oscillation d'un angle d'inclinaison α formé entre un axe principal Aₛ orthogonal au substrat et un axe fixe A_{f} parallèle à la direction principale de dépôt D_{d} allant au plus à une valeur seuil αₜₕ égale à arctan(d/h) et incluant la valeur 0°, à une fréquence d'oscillation angulaire fₒ; les fréquences de rotation fᵣ et d'oscillation angulaire fₒ étant prédéfinies de sorte que la couche mince conductrice inférieure est déposée de manière conforme et continue sur le substrat et les flancs des diodes filaires.

Certains aspects préférés mais non limitatifs de ce procédé de fabrication sont les suivants.

L'étape de réalisation de la couche mince conductrice inférieure peut être effectuée par évaporation ou par pulvérisation par faisceau d'ions.

Le support et donc le substrat peuvent présenter un mouvement de rotation autour de l'axe principal Aₛ et un mouvement d'oscillation angulaire de l'axe principal Aₛ vis-à-vis de l'axe fixe A_{f} de sorte que l'angle d'incidence α varie entre -αₘ et +αₘ, où la valeur maximale αₘ est au plus égale à la valeur seuil αₜₕ.

Le support et donc le substrat peuvent présenter un mouvement de rotation de l'axe principal Aₛ autour de l'axe fixe A_{f}, l'axe fixe A_{f} étant sécant de l'axe principal Aₛ, et un mouvement d'oscillation angulaire de l'angle d'incidence α de sorte que l'angle d'incidence α varie entre 0 et +αₘ, où la valeur maximale αₘ est au plus égale à la valeur seuil αₜₕ.

Les diodes filaires peuvent être réalisées à base d'un composé III-V, II-VI ou d'un élément ou d'un composé IV.

Les diodes filaires peuvent présenter une hauteur moyenne h comprise entre 500nm et 5000nm, et l'espacement relatif moyen peut être compris entre 50nm et 500nm, tout en respectant un rapport d'aspect d'espacement au moins égal à 1.

Lors de l'étape de réalisation de la couche mince conductrice inférieure, les diodes filaires peuvent être entièrement recouvertes par la couche mince conductrice inférieure.

Les diodes filaires peuvent comporter, à partir du substrat et suivant l'axe principal Aₛ, une première portion dopée selon un premier type de conductivité, une zone active et une deuxième portion dopée selon un deuxième type de conductivité opposé au premier type.

Le procédé de fabrication peut comporter une étape de suppression d'une partie de la couche mince conductrice inférieure s'étendant sur la zone active et la deuxième portion dopée, pour ne garder qu'une partie de la couche mince conductrice inférieure s'étendant sur la première portion dopée.

L'étape de suppression peut être configurée de sorte que, ensuite, la couche mince conductrice inférieure s'étend sur la première portion dopée des diodes filaires sur une hauteur hₑᵢ supérieure à une épaisseur eₑᵢ de la couche mince conductrice inférieure s'étendant sur le substrat.

### BRÈVE DESCRIPTION DES DESSINS

D'autres aspects, buts, avantages et caractéristiques de l'invention apparaîtront mieux à la lecture de la description détaillée suivante de formes de réalisation préférées de celle-ci, donnée à titre d'exemple non limitatif, et faite en référence aux dessins annexés sur lesquels :

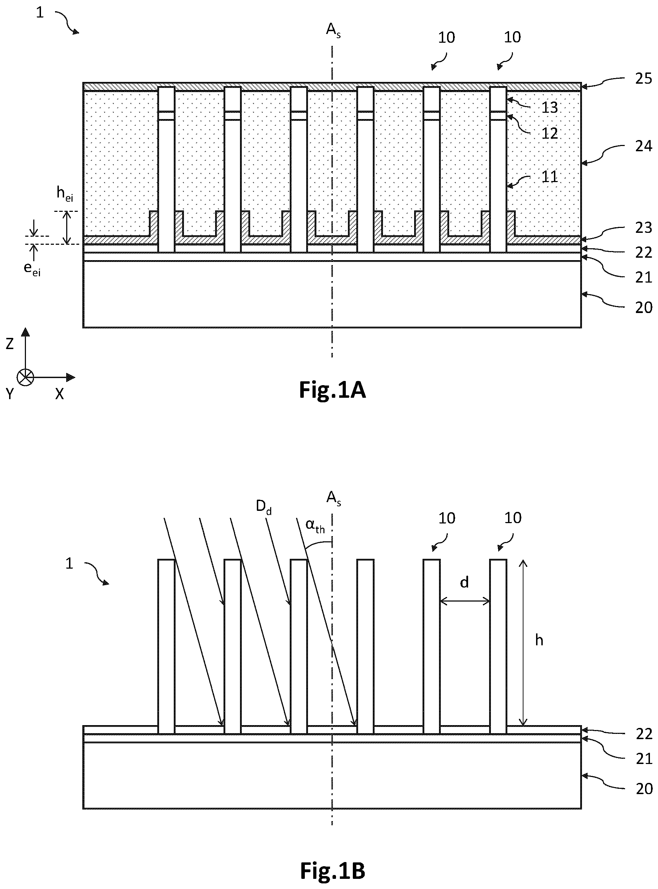

la figure 1A est une vue en coupe, schématique et partielle, d'un dispositif optoélectronique obtenu par un procédé de fabrication selon un mode de réalisation, dans lequel l'électrode inférieure est une couche mince qui s'étend de manière conforme et continue sur le substrat et sur les pieds de diodes filaires ;
la figure 1B est une vue en coupe, schématique et partielle, d'une partie du dispositif optoélectronique illustré sur la fig.1A, illustrant le rapport d'aspect de l'espacement h/d entre les diodes filaires ainsi que la direction principale de dépôt D_{d} de l'électrode inférieure en couche mince ;

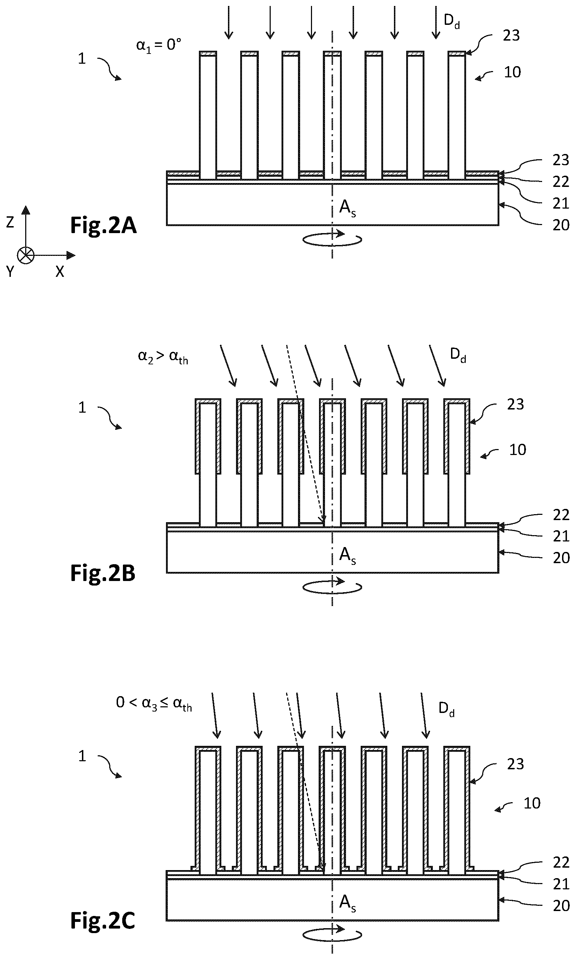

les figures 2A à 2C sont des vues en coupe, schématiques et partielles, d'un dispositif optoélectronique à diodes filaires, illustrant différentes configurations de dépôt de l'électrode inférieure en couche mince pour différentes valeurs d'angle d'inclinaison α entre la direction principale de dépôt et l'axe principal Aₛ du substrat ;

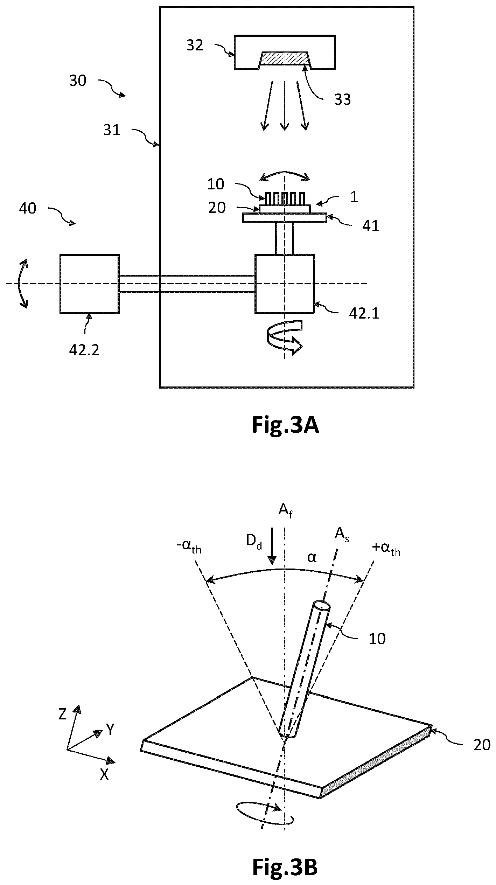

La figure 3A illustre un réacteur de dépôt de l'électrode inférieure en couche mince selon un premier mode de réalisation, dans lequel le support du substrat est rotatif autour de l'axe principal Aₛ du substrat, cet axe principal Aₛ présentant en outre un mouvement planaire d'oscillation angulaire autour de la direction principale de dépôt D_{d}, et plus précisément autour d'un axe fixe A_{f} parallèle à la direction principale de dépôt D_{d} et sécant à l'axe principal Aₛ, de sorte que l'angle d'inclinaison α varie entre au plus -αₜₕ et +αₜₕ ; ;
La figure 3B illustre une partie du dispositif optoélectronique au cours de l'étape de réalisation de l'électrode inférieure en couche mince dans le réacteur illustré sur la fig.3A, mettant en évidence les mouvements de rotation et d'oscillation angulaire du substrat ;

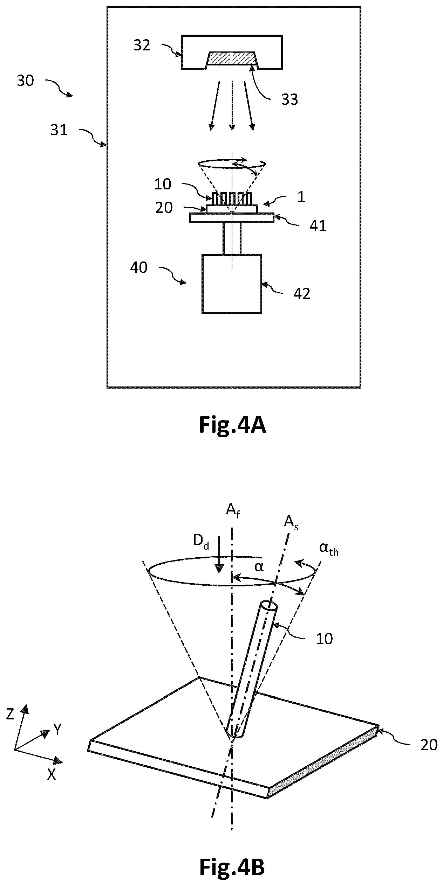

La figure 4A illustre un réacteur de dépôt de l'électrode inférieure en couche mince selon un deuxième mode de réalisation, dans lequel le support du substrat n'est pas rotatif autour de l'axe principal Aₛ (contrairement au cas de la fig.3A), mais présente un mouvement de rotation de l'axe principal Aₛ du substrat autour d'un axe fixe A_{f} parallèle à la direction principale de dépôt D_{d}, ainsi qu'un mouvement d'oscillation angulaire de sorte que l'angle d'inclinaison α varie entre 0° et au plus αₜₕ ;
La figure 4B illustre une partie du dispositif optoélectronique au cours de l'étape de réalisation de l'électrode inférieure en couche mince illustré sur la fig.4A, mettant en évidence les mouvements de rotation de l'axe principal Aₛ du substrat autour de l'axe fixe A_{f} et d'oscillation angulaire du substrat ;

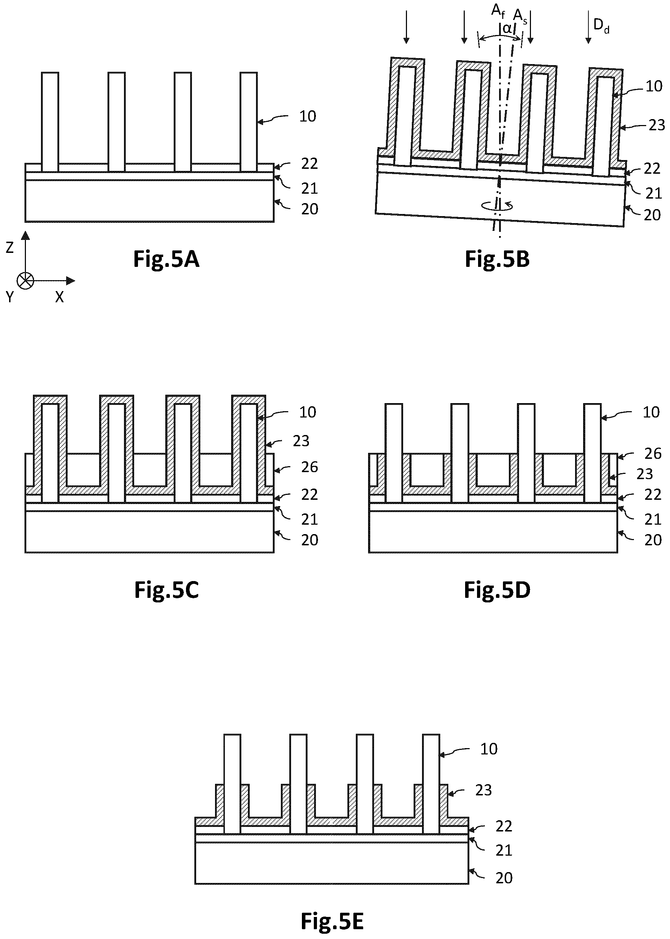

Les figures 5A à 5E illustrent différentes étapes d'un procédé de fabrication d'un dispositif optoélectronique selon le premier mode de réalisation.

### EXPOSÉ DÉTAILLÉ DE MODES DE RÉALISATION PARTICULIERS

Sur les figures et dans la suite de la description, les mêmes références représentent les éléments identiques ou similaires. De plus, les différents éléments ne sont pas représentés à l'échelle de manière à privilégier la clarté des figures. Par ailleurs, les différents modes de réalisation et variantes ne sont pas exclusifs les uns des autres et peuvent être combinés entre eux. Sauf indication contraire, les termes « sensiblement », « environ », « de l'ordre de » signifient à 10% près, et de préférence à 5% près. Par ailleurs, les termes « compris entre ... et ... » et équivalents signifient que les bornes sont incluses, sauf mention contraire.

L'invention porte sur un procédé de fabrication d'un dispositif optoélectronique comportant des diodes filaires de type diodes électroluminescentes ou photodiodes. Il comporte en particulier une étape de réalisation d'une couche mince conductrice, destinée à former une électrode inférieure, s'étendant de manière conforme et continue sur le substrat et le pied des diodes filaires, au moyen d'une technique de dépôt physique en phase vapeur directif. Le procédé de fabrication permet alors d'obtenir une électrode inférieure en couche mince, située en face avant du substrat, et permettant une injection améliorée des porteurs de charges en pied des diodes filaires.

Les diodes filaires sont des structures semiconductrices tridimensionnelles qui présentent une forme allongée suivant un axe principal Aₛ orthogonal au substrat, c'est-à-dire dont la dimension longitudinale (hauteur moyenne h) suivant l'axe principal Aₛ est supérieure aux dimensions transversales (diamètre moyen). Les diodes sont alors appelées diodes filaires. Les dimensions transversales des fils, c'est-à-dire leurs dimensions dans un plan orthogonal à l'axe principal As, forment un diamètre moyen compris entre 5nm et 5µm. La hauteur moyenne h des diodes filaires est supérieure au diamètre moyen, par exemple 2 fois, 5 fois et de préférence au moins 10 fois supérieure. Les diodes filaires peuvent également présenter une forme où les flancs ne sont pas verticaux (nano- ou micro-pyramides).

La section droite des fils, dans un plan orthogonal à l'axe principal Aₛ, peut présenter différentes formes, par exemple une forme circulaire, ovale, polygonale par exemple triangulaire, carrée, rectangulaire voire hexagonale. On définit ici le diamètre comme étant une grandeur associée au périmètre du fil au niveau d'une section droite. Il peut s'agir du diamètre d'un disque présentant la même surface que la section droite du fil. Le diamètre local est le diamètre du fil à une hauteur donnée de celui-ci suivant l'axe principal Aₛ. Le diamètre moyen est la moyenne, par exemple arithmétique, des diamètres locaux le long du fil ou d'une portion de celui-ci.

Les diodes filaires reposent sur un substrat et sont espacées les unes des autres avec un espacement relatif moyen d de flanc à flanc, c'est-à-dire suivant une distance moyenne dans un plan parallèle au substrat allant d'un flanc (bord) de diode filaire à un flanc (bord) d'une diode filaire voisine. On peut alors définir un rapport d'aspect d'espacement comme le rapport h/d de la hauteur moyenne h sur l'espacement relatif moyen d. Dans le cadre de l'invention, ce rapport d'aspect d'espacement est au moins égal à 1, et de préférence au moins égal à 5 voire davantage. Autrement dit, les diodes filaires présentent une hauteur moyenne h élevée vis-à-vis de l'espacement relatif moyen d, et/ou un espacement relatif moyen d faible vis-à-vis de hauteur moyenne h.

Par ailleurs, le procédé de fabrication selon l'invention comporte plus particulièrement une étape de réalisation sur la face avant du substrat d'une couche mince conductrice, destinée à former une électrode de polarisation dite électrode inférieure, de sorte que l'électrode inférieure s'étend de manière continue et conforme sur le substrat et au moins une partie des diodes filaires. L'électrode inférieure est alors en mesure de polariser électriquement toutes ou au moins une partie des diodes filaires, lesquelles sont alors connectées en parallèle. Par couche mince, on entend une couche déposée ici par une technique de dépôt physique en phase vapeur directif dont l'épaisseur est de préférence inférieure au diamètre moyen des diodes filaires, par exemple au diamètre moyen divisé par 2.

Ainsi, chaque partie de la couche mince conductrice située sur les flancs d'une diode filaire est continûment reliée à la partie qui s'étend sur le substrat (ici sur une couche de nucléation ou un masque de croissance) et entoure le pied de chaque diode filaire. La couche mince conductrice déposée prend la forme d'une couche déposée de manière conforme (dépôt conforme) alors même qu'elle est réalisée par une technique de dépôt physique en phase vapeur directif, selon une direction principale de dépôt D_{d} prédéfinie. Le dépôt physique en phase vapeur directif peut être, entre autres, un dépôt par évaporation sous vide par effet Joule ou par faisceau d'électrons (*Electron Beam Evaporation,* en anglais), ou un dépôt par pulvérisation par faisceau d'ions (*Ion Beam Sputtering,* en anglais).

On utilise donc une technique de dépôt directif qui n'appartient pas à la famille des techniques de dépôt conforme de couche mince, mais ici le dépôt de la couche mince conductrice est rendu conforme par les mouvements de rotation et d'oscillation angulaire décrits plus loin. Ainsi, du fait de la définition de ce qu'est un dépôt conforme, la couche mince conductrice suit la topologie des éléments qu'elle recouvre. Elle présente alors une épaisseur, définie suivant un axe orthogonal à la surface qu'elle recouvre, homogène ou sensiblement homogène. Autrement dit, l'épaisseur peut être constante, sensiblement constante, i.e. elle peut varier entre une valeur maximale au niveau du substrat et une valeur minimale au niveau des flancs des diodes filaires. A titre purement illustratif, pour un dépôt conforme d'une couche mince de 20nm, l'épaisseur de la couche peut varier, dans certaines conditions (par ex. avec le rapport d'espacement h/d très grand), entre une valeur de 1nm au niveau des flancs latéraux des diodes filaires et une valeur de 20nm au niveau de la surface du substrat.

La figure 1A est une vue en coupe, schématique et partielle, d'un dispositif optoélectronique 1 obtenu par un procédé de fabrication selon un mode de réalisation. Le dispositif optoélectronique 1 comporte une matrice de diodes filaires 10, ici des diodes électroluminescentes réalisées à base de GaN en configuration axiale. Toutefois, les diodes filaires 10 peuvent présenter d'autres configurations, comme une configuration de type cœur coquille.

On définit ici et pour la suite de la description un repère orthonormé tridimensionnel XYZ où le plan XY est sensiblement parallèle au plan d'un substrat 20 du dispositif optoélectronique 1, l'axe Z étant orienté suivant une direction orthogonale au plan du substrat 20 en direction des diodes filaires 10.

Dans cet exemple, le dispositif optoélectronique 1 comporte :
- un substrat 20, par exemple réalisé en un matériau électriquement isolant ou conducteur, présentant deux faces, dite arrière et avant, opposées l'une à l'autre ;
- une couche de nucléation 21, réalisée en un matériau adapté à la croissance épitaxiale des diodes filaires 10 et ici électriquement isolante, recouvrant la face avant du substrat 20 ;
- un masque de croissance 22, réalisé en un matériau électrique isolant ;
- une couche mince conductrice 23 inférieure, destinée à former l'électrode inférieure, ici s'étendant de manière conforme et continue sur le substrat 20 et sur une partie inférieure des diodes filaires 10 ;
- des diodes filaires 10, qui s'étendent à partir de la couche de nucléation 21 suivant un axe principal As du substrat 20, orienté de manière orthogonale au substrat 20 ;
- une couche d'encapsulation 24, réalisée en un matériau électriquement isolant, qui remplit l'espace latéral entre les diodes filaires 10 et les recouvre ;
- une couche mince conductrice 25 supérieure, destinée à former l'électrode supérieure, reposant sur la couche d'encapsulation 24, et en contact avec une partie supérieure des diodes filaires 10.

Le substrat 20 peut être une structure monobloc en un même matériau ou multicouches. Il peut être réalisé en un composé semiconducteur IV, par exemple en silicium, en germanium, en carbure de silicium, ou en un composé III-V (tel que l'AIN ou le GaN) ou II-VI. Il peut également être en un matériau métallique ou en un matériau isolant comme le saphir. Dans cet exemple, il est réalisé à base de silicium.

Le face avant du substrat 20 est ici recouverte par une couche de nucléation 21. Celle-ci est réalisée en un matériau favorisant la nucléation et la croissance épitaxiale des diodes filaires 10, et peut être un oxyde d'aluminium (tel que l'Al₂O₃), un nitrure de magnésium MgₓN_{y}, ou un nitrure ou un carbure d'un métal de transition, ou tout autre matériau adapté ici pour l'épitaxie du GaN. L'épaisseur de la couche de nucléation 21 peut être de l'ordre de quelques nanomètres à quelques centaines de nanomètres.

La couche de nucléation 21 est ici recouverte par une couche diélectrique 22 formant un masque de croissance, laquelle comporte des ouvertures débouchant sur la couche de nucléation 21 et autorisant la croissance épitaxiale des diodes filaires 10. La couche diélectrique 22 est réalisée en au moins un matériau électriquement isolant, par exemple un oxyde ou un nitrure de silicium, tel que du SiO₂ ou du Si₃N₄. Dans cet exemple, la couche diélectrique 22 est réalisée en SiO₂.

Chaque diode filaire 10 est ici une diode électroluminescente en configuration axiale. Elle s'étend longitudinalement de manière parallèle à l'axe principal Aₛ du substrat. Elle comporte, suivant l'axe principal Aₛ, une première portion dopée 11, par exemple ici de type n, s'étendant au contact et à partir de la couche de nucléation 21, une zone active 12 d'où est émis l'essentiel du rayonnement lumineux de la diode, et une deuxième portion dopée 13, ici de type p.

Les diodes filaires 10 sont ici en configuration axiale dans la mesure où chaque zone active 12 revêt essentiellement une face supérieure de la première portion dopée 11 et s'étend suivant l'axe principal Aₛ. De plus, chaque seconde portion dopée 13 revêt essentiellement une face supérieure de la zone active 12 et s'étend également suivant l'axe principal Aₛ. Les diodes filaires 10 se distinguent ici de la configuration cœur/coquille (qui peut toutefois être mise en œuvre dans le cadre du procédé selon l'invention).

Chaque diode filaire 10 est réalisée ici à base de GaN, mais plus généralement à partir d'au moins un matériau semiconducteur, qui peut être choisi parmi les composés III-V comportant au moins un élément de la colonne III et au moins un élément de la colonne V du tableau périodique ; les composés II-VI comportant au moins un élément de la colonne Il et au moins un élément de la colonne VI ; ou les éléments ou composés IV comportant au moins un élément de la colonne IV.

Les diodes filaires 10 sont réparties sur le substrat 20 de manière régulière, avec un espacement relatif moyen d de bord à bord. On peut alors définir un rapport d'aspect de l'espacement entre les diodes filaires 10, comme le rapport h/d correspondant au rapport de la hauteur moyenne h sur l'espacement relatif moyen d. La hauteur moyenne peut être comprise entre 100nm et 10000nm, par exemple comprise entre 500nm et 5000nm, et de préférence comprise entre 800nm et 1200nm. L'espacement relatif moyen peut être compris entre 50nm et 500nm, voire entre 80nm et 120nm. Quoi qu'il en soit, le rapport d'aspect h/d est au moins égal à 1, voire à 5, ou encore à 10.

Par ailleurs, la couche mince conductrice 23 s'étend de manière conforme et continue sur le substrat 20 et sur une partie inférieure de chaque diode filaire 10 (pied de la diode filaire). Elle peut donc assurer la polarisation électrique des diodes filaires 10, c'est-à-dire l'application d'un même potentiel électrique à chaque première portion dopée 11 des diodes filaires 10. Ces dernières sont alors connectées en parallèle.

La couche mince conductrice 23 est réalisée en au moins un matériau électriquement conducteur, comme par exemple un matériau métallique tel que de l'aluminium, de l'argent, ou un matériau transparent conducteur tel qu'un oxyde d'indium étain (ITO, pour *Indium Tin Oxide* en anglais) ou tout autre matériau permettant d'établir un contact électrique sur la première portion dopée 11. L'épaisseur moyenne eₑᵢ de la couche mince conductrice 23 peut être comprise entre 50nm et 500nm, par exemple égale à 100nm.

Elle s'étend de manière conforme sur le substrat 20 et les diodes filaires 10, c'est-à-dire qu'elle présente une épaisseur non nulle à la fois sur le substrat 20 et sur les pieds des diodes filaires 10. De manière à améliorer la polarisation électrique des diodes filaires, elle s'étend le long des pieds des diodes filaires 10 sur une hauteur moyenne hₑᵢ supérieure à son épaisseur moyenne eₑᵢ, par exemple égale à 500nm environ. De plus, elle s'étend de manière continue, c'est-à-dire que la partie qui s'étend continûment sur le substrat 20 est également continûment reliée aux parties qui s'étendent sur les pieds des diodes filaires 10.

Les diodes filaires 10 sont recouvertes par une couche d'encapsulation 24, réalisée en un matériau diélectrique et au moins partiellement transparent au rayonnement lumineux émis par les diodes filaires 10. Il peut s'agir, par exemple, d'un oxyde de silicium (par exemple SiO2) ou d'aluminium (par exemple Al2O3), d'un nitrure de silicium SiNx ou tout autre matériau adapté comme par exemple un polymère. L'épaisseur de la couche d'encapsulation 24 est telle qu'elle recouvre les diodes filaires 10, mais laisse affleurer une partie de la deuxième portion dopée 13 des diodes filaires 10.

Enfin, une couche mince conductrice 25 supérieure, destinée à former l'électrode supérieure, s'étend sur la couche d'encapsulation 24 et vient au contact de la deuxième portion dopée 13 de chaque diode filaire 10. Elle est réalisée en un matériau électriquement conducteur, et transparent au rayonnement lumineux émis par les diodes. Il peut s'agir, par exemple, d'un oxyde d'indium étain (ITO) ou d'un oxyde de zinc dopé au gallium (GZO), voire dopé à l'aluminium ou à l'indium. Par transparent, ou au moins partiellement transparent, on entend un matériau qui transmet au moins 50% de la lumière incidente, et de préférence au moins 80% voire davantage.

La figure 1B est une vue simplifiée d'une partie du dispositif optoélectronique 1 illustrée sur la fig.1A, avant l'étape de réalisation de la couche mince conductrice 23 inférieure.

On met ici en évidence le rapport d'aspect d'espacement h/d des diodes filaires 10 vis-à-vis de la direction principale de dépôt D_{d} (ou direction d'incidence) du flux de matière destiné à former l'électrode inférieure 23.

En effet, dans la mesure où cette étape de réalisation est effectuée par dépôt physique en phase vapeur directif (évaporation, pulvérisation IBS...), le flux de matière est orienté, au niveau du substrat 20 et des diodes filaires 10, suivant une direction principale D_{d} prédéfinie.

Cette direction principale D_{d} peut être inclinée ou non vis-à-vis de l'axe principal Aₛ orthogonal au substrat 20. On définit alors un angle d'inclinaison α, qui peut être nul lorsque l'axe principal Aₛ est parallèle à la direction principale D_{d}, ou qui est non nul lorsque l'axe principal Aₛ est incliné vis-à-vis de cette direction principale D_{d}.

On remarque alors que, en fonction du rapport d'aspect d'espacement h/d et de l'angle d'inclinaison α, un phénomène d'ombrage peut avoir lieu, ce qui se traduit par le fait que la couche mince conductrice 23 peut présenter différentes configurations très différentes en fonction de la valeur de l'angle d'inclinaison α, dont certaines sont peu propices à assurer une polarisation électrique efficace des premières portions dopées 11 des diodes filaires 10, tandis que d'autres configurations ne permettent pas d'assurer cette polarisation électrique.

Ce phénomène d'ombrage a lieu lorsque l'angle d'incidence α est supérieur à une valeur seuil αₜₕ égale à arctan(d/h). En deçà de cette valeur seuil αₜₕ, le flux de matière atteint la surface du substrat 20, et au-delà de cette valeur seuil, ce n'est plus le cas.

A ce titre, les figures 2A à 2C sont des vues en coupe, schématiques et partielles, d'un dispositif optoélectronique 1 après l'étape de réalisation de la couche mince conductrice 23 inférieure, pour différentes valeurs de l'angle d'inclinaison α et donc pour différentes configurations obtenues.

Dans ces exemples, le substrat 20 repose sur un support 41 d'un porte-substrat 40 (cf. fig.3A et 4A). Lors de l'étape de réalisation de la couche mince conductrice 23, le support 41 est rotatif autour de l'axe principal Aₛ du substrat 20.

La figure 2A illustre le cas où un dépôt directif est effectué avec un angle d'incidence α constant égal à zéro : l'axe principal Aₛ est parallèle à la direction principale D_{d} de dépôt. La couche mince conductrice 23 s'étend alors continûment sur le substrat 20 (i.e. ici sur la couche diélectrique 22), entre les diodes filaires 10, ainsi que sur une surface supérieure de ces dernières. La surface de contact de la couche mince conductrice 23 sur les pieds des diodes filaires 10 est négligeable puisque la couche mince conductrice 23 ne remonte pas le long d'une partie des diodes filaires 10 (pas un dépôt conforme). De plus, le contact physique et donc électrique n'est pas assuré car le dépôt de la couche mince conductrice 23 n'est pas dirigé vers le semiconducteur 11. Il en résulte une mauvaise injection des porteurs de charge dans les premières portions dopées 11.

La figure 2B illustre le cas où un dépôt directif est effectué avec un angle d'incidence α constant supérieur (strictement) à la valeur seuil αₜₕ. Il apparaît alors que le rapport d'aspect d'espacement élevé, ici de l'ordre de 4 environ, provoque un effet d'ombrage par les diodes filaires 10 qui empêche le flux de matière incident d'attendre la surface du substrat 20. Aussi, la couche mince conductrice 23 n'est déposée que sur une partie supérieure des diodes filaires 10, et non pas sur la partie inférieure des diodes filaires 10 ni sur la surface du substrat 20. Aussi, la couche mince conductrice 23 ne peut assurer une fonction de polarisation électrique.

La figure 2C illustre le cas où un dépôt directif est effectué avec un angle d'incidence α constant compris entre 0 (non inclus) et la valeur seuil αₜₕ. Puisque l'angle d'incidence α est inférieur ou égal à la valeur seuil αₜₕ, la couche mince conductrice 23 est déposée sur toute la surface des diodes filaires 10 ainsi que sur une partie de la surface du substrat 20 qui entoure les diodes filaires 10. Cependant, l'angle d'incidence α est non nul, de sorte que le flux de matière n'atteint pas une partie de la surface du substrat 20 qui entoure chaque diode filaire 10. Il en résulte ici également un défaut de continuité de l'étendue surfacique de la couche mince conductrice 23, de sorte qu'il n'est pas possible de polariser électriquement toutes les diodes filaires 10 car elles ne sont alors pas connectées en parallèle par la couche mince conductrice 23 déposée.

Aussi, selon l'invention, la couche mince conductrice 23 est réalisée par dépôt directif et en combinant un mouvement de rotation avec un mouvement d'oscillation angulaire du substrat 20. Ainsi, la couche mince conductrice 23 est déposée continûment et de manière conforme sur le substrat 20 et sur toute la surface, ou au moins une partie inférieure des diodes filaires 10. La couche mince conductrice 23 peut alors former une électrode inférieure en couche mince, déposée sur la face avant du substrat 20, et qui assure une polarisation électrique des diodes filaires 10.

Deux modes de réalisation principaux sont décrits par la suite. Dans un premier mode, le substrat 20 présente un mouvement de rotation autour de son axe principal Aₛ à une fréquence de rotation fᵣ, ainsi qu'un mouvement d'oscillation angulaire de l'axe principal Aₛ vis-à-vis d'un axe fixe A_{f} parallèle à la direction principale D_{d} de dépôt à une fréquence d'oscillation angulaire fₒ de sorte que l'angle d'incidence α varie entre -αₘ et +αₘ, où la valeur maximale αₘ est au plus égale à la valeur seuil αₜₕ. Dans ce cas, le mouvement d'oscillation angulaire a lieu dans un plan contenant l'axe fixe Aᵣ.

Dans un deuxième mode, le substrat 20 présente un mouvement de rotation de son axe principal Aₛ autour d'un axe fixe A_{f} parallèle à la direction principale D_{d} de dépôt, l'axe fixe A_{f} étant sécant de l'axe principal Aₛ, à une fréquence de rotation fᵣ, ainsi qu'un mouvement d'oscillation angulaire de l'angle d'incidence α (qui forme alors un angle de nutation) à une fréquence d'oscillation angulaire fₒ de sorte que l'angle d'incidence α varie entre 0 et +αₘ, où la valeur maximale αₘ est inférieure ou égale à la valeur seuil αₜₕ. Dans ce mode de réalisation, le substrat 20 n'est pas en rotation autour de son axe principal Aₛ (on peut parler d'un mouvement de précession de l'axe Aₛ autour de l'axe Aᵣ selon un angle de précession α variable).

Dans ces deux modes de réalisation, la fréquence de rotation fᵣ et la fréquence d'oscillation angulaire fₒ sont prédéfinies de sorte que la couche mince conductrice sont déposées de manière continue et conforme sur le substrat 20 et sur les diodes filaires 10.

La figure 3A est une vue schématique et partielle, en coupe transversale, d'un réacteur 30 de dépôt en couche mince et d'un dispositif optoélectronique 1 en cours de fabrication, selon le premier mode de réalisation. La figure 3B illustre, de manière schématique, le substrat 20 et une diode filaire 10 au cours de l'étape de réalisation de la couche mince conductrice 23 dans le réacteur de la fig.3A.

Le réacteur 30 est un réacteur de dépôt physique en phase vapeur directif, par exemple de type à évaporation ou à pulvérisation IBS, entre autres. Il comporte une enceinte étanche 31 dans laquelle est situé un creuset 32 recevant l'échantillon 33 du matériau conducteur à déposer. Il comporte également un porte-substrat 40 adapté à assurer le mouvement de rotation et le mouvement d'oscillation angulaire du substrat 20.

Le porte-substrat 40 comporte un support 41 recevant le substrat 20, et un dispositif mécanique assurant le mouvement du support 41. Ce dispositif mécanique comporte ici un premier moteur 42.1 assurant le mouvement de rotation autour d'un axe principal du support 41, qui est ici colinéaire avec l'axe principal As du substrat 20. Il comporte également un deuxième moteur 42.2 assurant le mouvement d'oscillation angulaire de l'axe principal Aₛ vis-à-vis d'un axe fixe A_{f}. Cet axe fixe A_{f} passe ici par le centre du creuset 32 et par le centre de rotation du substrat 20. Dans cet exemple, le moteur 42.1 est situé à l'intérieur de l'enceinte 31 et le moteur 42.2 en est situé à l'extérieur, les connexions étant assurées par des passages étanches. D'autres agencements sont bien entendu possibles.

A titre d'exemple, la valeur seuil αₜₕ est égale à 5°, ce qui correspond à un rapport d'aspect d'espacement h/d égal à 10 environ, par exemple pour une hauteur moyenne h de l'ordre de 1000nm et un espacement relatif moyen d de l'ordre de 100nm. L'oscillation angulaire est régulière entre -5° et +5°, et une oscillation peut être effectuée en quelques secondes. Aussi, pendant la durée de l'étape de réalisation de la couche mince conductrice, plusieurs oscillations angulaires sont effectuées. Par ailleurs, la fréquence de rotation fᵣ peut être de l'ordre de 10rpm.

De préférence, pour éviter que le flux de matière incident ne voie toujours la même surface des flancs des diodes filaires 10, la fréquence de rotation fᵣ et la fréquence d'oscillation angulaire fₒ sont des nombres premiers entre eux, dans le sens où elles ne comportent pas de multiplicateur commun. Autrement dit, la fréquence de rotation fᵣ n'est pas un multiple de la fréquence d'oscillation angulaire fₒ, et inversement. Cependant, il s'agit ici de conditions avantageuses mais non strictement nécessaires. En effet, si les fréquences fᵣ et fₒ ne sont pas des nombres premiers entre elles mais diffèrent légèrement, par exemple à 10% près voire moins, la couche mince conductrice 23 sera tout de même déposée de manière continue et conforme sur la surface du substrat 20 et les diodes filaires 10 si le procédé de dépôt dure assez longtemps pour que toutes les parties des diodes filaires soient exposées au flux de matière de la couche 23. De plus, si la fréquence d'oscillation angulaire fₒ est un multiple de la fréquence de rotation fᵣ, mais bien plus élevée, par exemple avec un rapport 10 voire plus, ou inversement, la couche mince conductrice 23 sera également déposée de manière continue et conforme.

La figure 4A est une vue schématique et partielle, en coupe transversale, d'un réacteur 30 de dépôt en couche mince et du dispositif optoélectronique 1 en cours de fabrication, selon le deuxième mode de réalisation. La figure 4B illustre, de manière schématique, le substrat 20 et une diode filaire 10 au cours de l'étape de réalisation de la couche mince conductrice 23 dans le réacteur de la fig.4A.

Le réacteur 30 est ici également un réacteur de dépôt physique en phase vapeur directif, par exemple de type à évaporation ou à pulvérisation IBS, entre autres. Il comporte une enceinte étanche 31 dans laquelle est situé un creuset 32 (ou une cible 32 dans le cas du dépôt IBS) recevant l'échantillon 33 du matériau conducteur à déposer. Il comporte également un porte-substrat 40 adapté à assurer le mouvement de rotation de l'axe principal Aₛ autour de l'axe fixe A_{f} ainsi que le mouvement d'oscillation angulaire de l'axe principal Aₛ.

Dans cet exemple, le dispositif mécanique du porte-substrat 40 comporte un même moteur 42 situé ici dans l'enceinte 31, assurant ces deux mouvements. Bien entendu, d'autres agencements sont possibles.

Un exemple de procédé de fabrication du dispositif optoélectronique 1, ici selon le premier mode de réalisation, est maintenant décrit en référence aux figures 5A à 5E. Les matériaux des différentes couches sont donnés ici à titre illustratif et d'autres matériaux peuvent être utilisés.

En référence à la fig.5A, on dépose une couche de nucléation 21 sur la face avant du substrat 20 en silicium, puis une couche diélectrique 22 (masque de croissance) en SiN comportant des ouvertures traversantes et débouchant sur la couche de nucléation 21. On réalise ensuite les diodes filaires 10 à base de GaN à partir de la couche de nucléation 21, par croissance épitaxiale au travers des ouvertures traversantes. Les diodes filaires 10 présentent ici une hauteur moyenne h comprise entre 800nm et 1200nm environ, et un espacement relatif moyen d compris entre 80nm et 120nm environ. On en déduit alors une valeur seuil αₜₕ de l'angle d'inclinaison α comprise entre 4° et 6°, soit ici de l'ordre de 5° environ.

En référence à la fig.5B, on réalise la couche mince conductrice 23 de sorte qu'elle s'étende de manière continue et conforme sur le substrat 20 (ici sur la couche diélectrique 22). Elle est réalisée en un matériau électriquement conducteur, par exemple ici en aluminium. Le dépôt est effectué par dépôt physique en phase vapeur directif, par exemple par évaporation ou par pulvérisation IBS, suivant une direction principale de dépôt D_{d}. Dans cet exemple, le support (non représenté) et donc le substrat 20 présentent un mouvement de rotation autour de l'axe principal Aₛ à une fréquence de rotation fᵣ égale à 10 rpm environ, ainsi qu'un mouvement d'oscillation angulaire autour de l'axe fixe A_{f} parallèle à la direction principale de dépôt D_{d} à une fréquence d'oscillation angulaire fₒ de l'ordre de 0.25 Hz environ, et d'une amplitude allant entre -5° et +5° environ.

En référence à la fig.5C, on dépose ensuite un masque de gravure 26 (résine) sur la structure obtenue, par exemple par enduction centrifuge (*spin coating* en anglais) suivi d'un amincissement au plasma O₂, de sorte qu'il présente une épaisseur uniforme suivant l'axe Z, et ne recouvre qu'une partie inférieure des diodes filaires 10. Aussi, le masque de gravure 26 recouvre la partie de la couche mince conductrice 23 qui s'étend sur le substrat 20 et une partie qui s'étend au contact de la partie inférieure des diodes filaires 10. Il garde libre une partie de la couche mince conductrice 23 qui s'étend sur une partie supérieure des diodes filaires 10 (qui comporte la zone active 12 et la deuxième portion dopée 13).

En référence à la fig.5D, on grave de manière sélective (gravure chimique humide, par exemple grâce à une solution commerciale appelée *Aluminium Etch,* à température ambiante) la partie libre de la couche mince conductrice 23, à savoir ici celle qui recouvre la partie supérieure des diodes filaires 10. La surface correspondante des diodes filaires 10 est alors rendue libre.

En référence à la fig.5E, on supprime le masque de gravure 26, par exemple en utilisant un bain de solvant comme l'acétone. On obtient alors une couche mince conductrice 23 qui s'étend de manière conforme et continue sur le substrat 20 (dans le plan XY) et sur une partie inférieure des diodes filaires 10 (suivant l'axe Z). La partie de la couche mince conductrice 23 s'étend sur les diodes filaires 10 sur une hauteur hₑᵢ supérieure à l'épaisseur eₑᵢ de la couche reposant sur le substrat 20. On peut ensuite continuer le procédé de fabrication du dispositif optoélectronique, par exemple en déposant une couche d'encapsulation puis une couche mince conductrice formant une électrode supérieure. Des plots de reprise de contact peuvent ensuite être déposés au contact de la couche mince conductrice inférieure (électrode inférieure) et de la couche mince conductrice supérieure (électrode supérieure) pour permettre la polarisation électrique des diodes filaires.

Des modes de réalisation particuliers viennent d'être décrits. Différentes variantes et modifications apparaîtront à l'homme du métier.

## Revendications

1. Procédé de fabrication d'un dispositif optoélectronique (1) comportant : un substrat (20), et une pluralité de diodes filaires (10) d'émission ou de détection de lumière reposant sur le substrat (20), présentant chacune une hauteur moyenne h et étant espacées avec un espacement relatif moyen d de flanc à flanc, tels qu'un rapport d'aspect d'espacement h/d est au moins égal à 1, **caractérisé en ce qu'**il comporte :
∘ une étape de réalisation d'une couche mince conductrice inférieure (23), en au moins un matériau électriquement conducteur, et destinée à former une électrode inférieure,
• effectuée par dépôt physique en phase vapeur directif suivant une direction principale de dépôt D_{d} orientée vers le substrat (20) et les diodes filaires (10), se traduisant par un flux de matière incident du matériau électriquement conducteur ;
• le substrat (20) reposant sur un support (41) d'un porte-substrat (40), le support (41) présentant :
- un mouvement périodique rotatif de sorte que les flancs des diodes filaires (10) sont exposés au flux de matière incident à une fréquence de rotation fᵣ; et
- un mouvement périodique d'oscillation d'un angle d'inclinaison α formé entre un axe principal Aₛ orthogonal au substrat (20) et un axe fixe A_{f} parallèle à la direction principale de dépôt D_{d} allant au plus à une valeur seuil αₜₕ égale à arctan(d/h) et incluant la valeur 0°, à une fréquence d'oscillation angulaire fₒ;
- les fréquences de rotation fᵣ et d'oscillation angulaire fₒ étant prédéfinies de sorte que la couche mince conductrice inférieure (23) est déposée de manière conforme et continue sur le substrat (20) et les flancs des diodes filaires (10).

2. Procédé de fabrication selon la revendication 1, dans lequel l'étape de réalisation de la couche mince conductrice inférieure (23) est effectuée par évaporation ou par pulvérisation par faisceau d'ions.

3. Procédé de fabrication selon la revendication 1 ou 2, dans lequel le support (41) et donc le substrat (20) présentent un mouvement de rotation autour de l'axe principal Aₛ et un mouvement d'oscillation angulaire de l'axe principal Aₛ vis-à-vis de l'axe fixe A_{f} de sorte que l'angle d'incidence α varie entre -αₘ et +αₘ, où la valeur maximale αₘ est au plus égale à la valeur seuil αₜₕ.

4. Procédé de fabrication selon la revendication 1 ou 2, dans lequel le support (41) et donc le substrat (20) présentent un mouvement de rotation de l'axe principal Aₛ autour de l'axe fixe A_{f}, l'axe fixe A_{f} étant sécant de l'axe principal Aₛ, et un mouvement d'oscillation angulaire de l'angle d'incidence α de sorte que l'angle d'incidence α varie entre 0 et +αₘ, où la valeur maximale αₘ est au plus égale à la valeur seuil αₜₕ.

5. Procédé de fabrication selon l'une quelconque des revendications 1 à 4, dans lequel les diodes filaires (10) sont réalisées à base d'un composé III-V comportant au moins un élément de la colonne III et au moins un élément de la colonne V du tableau périodique, d'un composé II-VI comportant au moins un élément de la colonne Il et au moins un élément de la colonne VI du tableau périodique, ou d'un élément ou d'un composé IV comportant au moins un élément de la colonne IV du tableau périodique.

6. Procédé de fabrication selon l'une quelconque des revendications 1 à 5, dans lequel les diodes filaires présentent une hauteur moyenne h comprise entre 500nm et 5000nm, et l'espacement relatif moyen est compris entre 50nm et 500nm, tout en respectant un rapport d'aspect d'espacement au moins égal à 1.

7. Procédé de fabrication selon l'une quelconque des revendications 1 à 6, dans lequel lors de l'étape de réalisation de la couche mince conductrice inférieure (23), les diodes filaires (10) sont entièrement recouvertes par la couche mince conductrice inférieure (23).

8. Procédé de fabrication selon l'une quelconque des revendications 1 à 7, dans lequel les diodes filaires (10) comportent, à partir du substrat (20) et suivant l'axe principal Aₛ, une première portion (11) dopée selon un premier type de conductivité, une zone active (12) et une deuxième portion (13) dopée selon un deuxième type de conductivité opposé au premier type.

9. Procédé de fabrication selon la revendication 8, comportant une étape de suppression d'une partie de la couche mince conductrice inférieure (23) s'étendant sur la zone active (12) et la deuxième portion (13) dopée, pour ne garder qu'une partie de la couche mince conductrice inférieure (23) s'étendant sur la première portion (11) dopée.

10. Procédé de fabrication selon la revendication 9, dans lequel l'étape de suppression est configurée de sorte que, ensuite, la couche mince conductrice inférieure (23) s'étend sur la première portion (11) dopée des diodes filaires (10) sur une hauteur hₑᵢ supérieure à une épaisseur eₑᵢ de la couche mince conductrice inférieure (23) s'étendant sur le substrat (20).

11. Procédé de fabrication selon l'une quelconque des revendications 1 à 10, dans lequel la fréquence de rotation fᵣ et la fréquence d'oscillation angulaire fₒ sont des nombres premiers entre eux.

12. Procédé de fabrication selon l'une quelconque des revendications 1 à 10, dans lequel la fréquence d'oscillation angulaire fₒ est un multiple de la fréquence de rotation fᵣ ou inversement, avec un rapport au moins égal à 10.

## Patentansprüche

1. Verfahren zur Herstellung einer optoelektronischen Vorrichtung (1), umfassend: ein Substrat (20), sowie eine Vielzahl von auf dem Substrat (20) aufgebrachten Licht emittierenden oder detektierenden Drahtdioden (10), die jeweils eine durchschnittliche Höhe h aufweisen und mit einem durchschnittlichen relativen Abstand d von Flanke zu Flanke beabstandet sind, sodass ein Seitenverhältnis des Abstands h/d mindestens gleich 1 ist, **dadurch gekennzeichnet, dass** es umfasst:
∘ einen Schritt zur Herstellung einer unteren leitfähigen Dünnschicht (23) aus mindestens einem elektrisch leitfähigen Material, die zur Bildung einer unteren Elektrode bestimmt ist,
• die durch physikalische Abscheidung aus der Gasphase (CVD) in einer Hauptabscheidungsrichtung D_{d} durchgeführt wird, die auf das Substrat (20) und die Drahtdioden (10) ausgerichtet ist, was zu einem einfallenden Materialstrom des elektrisch leitfähigen Materials führt;
• wobei das Substrat (20) auf einer Auflage (41) eines Substrathalters (40) ruht, welche Auflage (41) aufweist:
- eine periodische Drehbewegung, sodass die Flanken der Drahtdioden (10) mit einer Drehfrequenz fᵣ dem einfallenden Materialstrom ausgesetzt sind; und
- eine periodische Schwingungsbewegung mit einem Neigungswinkel α, der zwischen einer zum Substrat (20) senkrechten Hauptachse As und einer zur Hauptabscheidungsrichtung D_{d} parallelen festen Achse A_{f} gebildet wird, wobei dieser Winkel einen Schwellenwert αₜₕ von höchstens arctan(d/h) erreicht und den Wert 0° einschließt, bei einer Winkel-Schwingungsfrequenz fₒ;
- wobei die Rotationsfrequenz fᵣ und die Winkeloszillationsfrequenz fₒ so vorgegeben sind, dass die untere leitfähige Dünnschicht (23) konform und kontinuierlich auf dem Substrat (20) und den Flanken der Drahtdioden (10) aufgebracht wird.

2. Verfahren zur Herstellung nach Anspruch 1, bei dem der Schritt zur Herstellung der unteren leitfähigen Dünnschicht (23) durch Aufdampfen oder durch Ionenstrahlbeschichtung durchgeführt wird.

3. Herstellungsverfahren nach Anspruch 1 oder 2, bei dem der Träger (41) und damit das Substrat (20) eine Drehbewegung um die Hauptachse Aₛ und eine Winkeloszillationsbewegung der Hauptachse Aₛ gegenüber der festen Achse A_{f} aufweisen, so dass der Einfallswinkel α zwischen -αₘ und +αₘ variiert, wobei der Maximalwert αₘ höchstens gleich dem Schwellenwert αₜₕ ist.

4. Verfahren zur Herstellung nach Anspruch 1 oder 2, bei dem der Träger (41) und damit das Substrat (20) eine Drehbewegung der Hauptachse Aₛ um die feste Achse A_{f} ausführen, wobei die feste Achse A_{f} die Hauptachse Aₛ schneidet, und eine Winkeloszillationsbewegung des Einfallswinkels α aufweisen, sodass der Einfallswinkel α zwischen 0 und +αₘ variiert, wobei der Maximalwert αₘ höchstens gleich dem Schwellenwert αₜₕ ist.

5. Verfahren zur Herstellung nach einem der Ansprüche 1 bis 4, bei dem die Drahtdioden (10) aus einem Material auf Basis einer III-V-Verbindung hergestellt werden, die mindestens ein Element der Gruppe III und mindestens ein Element der Gruppe V des Periodensystems enthält, einer II-VI-Verbindung, die mindestens ein Element der Gruppe II und mindestens ein Element der Gruppe VI des Periodensystems enthält, oder eines Elements oder einer Verbindung der Gruppe IV, die mindestens ein Element der Gruppe IV des Periodensystems enthält.

6. Verfahren zur Herstellung nach einem der Ansprüche 1 bis 5, wobei die Drahtdioden eine durchschnittliche Höhe h zwischen 500 nm und 5 000 nm und einen durchschnittlichen Abstand zwischen 50 nm und 500 nm aufweisen, wobei ein Seitenverhältnis des Abstands von mindestens 1 eingehalten wird.

7. Verfahren zur Herstellung nach einem der Ansprüche 1 bis 6, bei dem im Schritt zur Herstellung der unteren leitfähigen Dünnschicht (23) die Drahtdioden (10) vollständig von der unteren leitfähigen Dünnschicht (23) bedeckt werden.

8. Verfahren zur Herstellung nach einem der Ansprüche 1 bis 7, bei dem die Drahtdioden (10) ausgehend vom Substrat (20) und entlang der Hauptachse Aₛ einen ersten Abschnitt (11) aufweisen, der mit einem ersten Leitfähigkeitstyp dotiert ist, sowie einen aktiven Bereich (12) und einen zweiten Abschnitt (13) aufweisen, der mit einem zweiten, dem ersten entgegengesetzten Leitfähigkeitstyp dotiert ist.

9. Verfahren zur Herstellung nach Anspruch 8, umfassend einen Schritt zum Entfernen eines Teils der unteren leitfähigen Dünnschicht (23), die sich über den aktiven Bereich (12) und den zweiten dotierten Abschnitt (13) erstreckt, um nur einen Teil der unteren leitfähigen Dünnschicht (23) zu belassen, der sich über den ersten dotierten Abschnitt (11) erstreckt.

10. Verfahren zur Herstellung nach Anspruch 9, wobei der Entfernungsschritt so ausgeführt ist, dass sich anschließend die untere leitfähige Dünnschicht (23) über den ersten dotierten Abschnitt (11) der Drahtdioden (10) auf einer Höhe hei erstreckt, die größer ist als eine Dicke eₑᵢ der unteren leitfähigen Dünnschicht (23), die sich über dem Substrat (20) erstreckt.

11. Verfahren zur Herstellung nach einem der Ansprüche 1 bis 10, wobei die Drehfrequenz fᵣ und die Winkelschwingungsfrequenz fₒ zueinander teilerfremde Zahlen sind.

12. Verfahren zur Herstellung nach einem der Ansprüche 1 bis 10, wobei die Winkeloszillationsfrequenz fₒ ein Vielfaches der Drehfrequenz fᵣ ist oder umgekehrt, wobei das Verhältnis mindestens 10 gleich ist.

## Claims

1. Method for manufacturing an optoelectronic device (1) comprising: a substrate (20), and a plurality of wire diodes (10) for emitting or detecting light resting on the substrate (20), each having an average height h and being spaced apart with an average relative spacing d from side to side, such that an h:d spacing aspect ratio is at least equal to 1, **characterised in that** it comprises:
∘ a step of producing a lower conductive thin film (23), made of at least one electrically conductive material, and intended to form a lower electrode;
• which step is carried out by directional physical vapour deposition in a main deposition direction D_{d} oriented towards the substrate (20) and the wire diodes (10), resulting in an incident material flow of the electrically conductive material;
• the substrate (20) resting on a support (41) of a substrate holder (40), the support (41) experiencing:
- a periodic rotational movement so that the sides of the wire diodes (10) are exposed to the incident material flow at a rotation frequency fᵣ; and
- a periodic oscillation movement of an angle of inclination α formed between a main axis Aₛ orthogonal to the substrate (20) and a fixed axis A_{f} parallel to the main deposition direction D_{d} ranging at most up to a threshold value αₜₕ equal to arctan(d:h) and including the value 0°, at an angular oscillation frequency fₒ;
- the frequencies of rotation fᵣ and of angular oscillation fₒ being predefined so that the lower conductive thin film (23) is deposited on the substrate (20) and the sides of the wire diodes (10) in a conformal and continuous manner.

2. Manufacturing method according to Claim 1, wherein the step of producing the lower conductive thin film (23) is carried out by evaporation or ion beam sputtering.

3. Manufacturing method according to Claim 1 or 2, wherein the support (41) and therefore the substrate (20) experience a rotation movement about the main axis Aₛ and an angular oscillation movement of the main axis Aₛ relative to the fixed axis A_{f}, so that the angle of incidence α varies between -αₘ and +αₘ, where the maximum value αₘ is at most equal to the threshold value αₜₕ.

4. Manufacturing method according to Claim 1 or 2, wherein the support (41) and therefore the substrate (20) experience a rotation movement of the main axis Aₛ about the fixed axis A_{f}, with the fixed axis A_{f} intersecting the main axis Aₛ, and experience an angular oscillation movement of the angle of incidence α, so that the angle of incidence α varies between 0 and +αₘ, where the maximum value αₘ is at most equal to the threshold value αₜₕ.

5. Manufacturing method according to any one of Claims 1 to 4, wherein the wire diodes (10) are produced from an III-V compound comprising at least one element from column III and at least one element from column V of the periodic table, from an II-VI compound comprising at least one element from column II and at least one element from column VI of the periodic table, or from an IV element or compound comprising at least one element from column IV of the periodic table.

6. Manufacturing method according to any one of Claims 1 to 5, wherein the wire diodes have an average height h ranging between 500 nm and 5,000 nm, and the average relative spacing ranges between 50 nm and 500 nm, while complying with a spacing aspect ratio that is at least equal to 1.

7. Manufacturing method according to any one of Claims 1 to 6, wherein, during the step of producing the lower conductive thin film (23), the wire diodes (10) are completely covered by the lower conductive thin film (23).

8. Manufacturing method according to any one of Claims 1 to 7, wherein the wire diodes (10) comprise, starting from the substrate (20) and along the main axis Aₛ, a first portion (11) doped according to a first type of conductivity, an active zone (12) and a second portion (13) doped according to a second type of conductivity opposite to the first type.

9. Manufacturing method according to Claim 8, comprising a step of removing part of the lower conductive thin film (23) extending over the active zone (12) and the second doped portion (13), in order to retain only part of the lower conductive thin film (23) extending over the first doped portion (11).

10. Manufacturing method according to Claim 9, wherein the removal step is configured so that, subsequently, the lower conductive thin film (23) extends over the first doped portion (11) of the wire diodes (10) to a height hₑᵢ that is greater than a thickness eₑᵢ of the lower conductive thin film (23) extending over the substrate (20).

11. Manufacturing method according to any one of Claims 1 to 10, wherein the rotation frequency fᵣ and the angular oscillation frequency fₒ are mutually prime numbers.

12. Manufacturing method according to any one of Claims 1 to 10, wherein the angular oscillation frequency fₒ is a multiple of the rotation frequency fᵣ, or vice versa, with a ratio that is at least equal to 10.
